Europäisches Patentamt

European Patent Office

Office européen des brevets

(11) Numéro de publication: **0 249 512**
**A1**

## (12) DEMANDE DE BREVET EUROPEEN

(21) Numéro de dépôt: **87400835.2**

(22) Date de dépôt: **13.04.87**

(51) Int. Cl.⁴: **H 01 H 47/00**
**H 05 K 7/20, H 02 G 3/00**

(30) Priorité: **14.04.86 FR 8605262**

(43) Date de publication de la demande:
**16.12.87 Bulletin 87/51**

(84) Etats contractants désignés:
**AT BE CH DE ES FR GB GR IT LI LU NL SE**

(71) Demandeur: **Nozick, Jacques E.**
**C.T.M. 28 rue Broca**
**F-75005 Paris (FR)**

**Lepaillier, Patrick**
**6 rue Gabrielle**
**F-92140 Clamart (FR)**

(72) Inventeur: **Nozick, Jacques E.**
**C.T.M. 28 rue Broca**
**F-75005 Paris (FR)**

**Lepaillier, Patrick**
**6 rue Gabrielle**
**F-92140 Clamart (FR)**

(74) Mandataire: **Pinguet, André**
**CAPRI 28 bis, avenue Mozart**
**F-75016 Paris (FR)**

(54) **Bloc de commutation centralisée modulaire.**

(57) Un bloc de commutation centralisée comporte :
. au moins un module de commutation de puissance amovible (7) comprenant un commutateur de puissance (26) assujetti à un organe de transfert thermique (23) et un composant électronique de réception (27) de signaux optiques ; et
. au moins un radiateur (8) comprenant au moins une surface pour coopérer étroitement avec l'organe de transfert thermique (23) du module (7) et diffuser la chaleur produite par le commutateur de puissance (26) dudit module.
Avantageusement, le radiateur (8) sert de support au module (7) ainsi qu'à un organe d'émission de signaux optiques (32), lequel est situé exactement en vis-à-vis du composant de réception de signaux optiques (27) quand le module (7) est correctement assujetti au radiateur. De la sorte, la connexion optique entre le composant électronique de réception (27) et l'organe d'émission de signaux optiques (32) n'est réalisée que si la liaison thermique entre l'organe de transfert thermique (23) et le radiateur (8) est assurée.

Fig. 4

EP 0 249 512 A1

**Description**

BLOC DE COMMUTATION CENTRALISEE MODULAIRE

La présente invention a pour objet un dispositif de connexion pour connecter un circuit de commande très basse tension à un (des) module(s) de commutation de puissance.

En règle générale, lorsqu'un circuit de puissance basse tension monophasé ou triphasé alimente une installation d'éclairage d'une certaine importance et/ou un ensemble d'appareils et de machines électriques, comme on peut en trouver constitués dans des locaux industriels, des locaux commerciaux et même des locaux d'habitation, les actionneurs des diverses sources de lumière et/ou des différents appareils ne sont pas disposés sur ledit circuit de puissance, mais sur un circuit de commande très basse tension.

Les avantages présentés par les installations électriques comportant un circuit double de ce type, -circuit de puissance basse tension/circuit de commande très basse tension (de l'ordre de 24 volts ou moins)-, tant sur le plan de la sécurité, que du coût et de la souplesse de mise en oeuvre sont bien connus et il serait superflu de les rappeler en détail. La demande de brevet européen no 86400222.5, qui décrit un dispositif de commutation centralisée pour un réseau électrique de bâtiment, en énumère quelques-uns concernant plus particulièrement les installations électriques pour locaux d'habitation. En contrepartie des nombreux avantages qu'elles offrent, les installations électriques à circuit double présentent une certaine complexité au niveau de la commutation du circuit de puissance par le circuit de commande, complexité que la demande de brevet européen citée ci-dessus se donne pour objet de maîtriser. Cette demande de brevet prévoit que, dans un réseau électrique de bâtiment comportant un circuit de puissance basse tension et un circuit très basse tension de commande du précédent, le circuit de puissance, qui comprend au moins une boucle connectée à au moins une source de lumière, une source de courant ou un appareil électrique quelconque, est relié par un bloc de commutation centralisée au circuit de commande, lequel comprend au moins une boucle connectée à au moins un actionneur ou un capteur. Ce bloc de commutation centralisée comporte au moins deux bornes d'alimentation du circuit de commande pour le raccordement d'une boucle du circuit de commande, au moins une borne d'entrée/sortie pour le raccordement d'une boucle du circuit de puissance et au moins un module de commutation pour établir la commutation entre une boucle de circuit de commande et une boucle de circuit de puissance, ledit module étant amovible. Ce module de commutation peut assurer diverses fonctions et faire office de télérupteur, télévariateur, minuterie, etc. Dans un mode particulier de réalisation décrit dans cette demande de brevet, le circuit de commande comporte au moins deux réglettes (soit une réglette A et une réglette B), la réglette A comprenant plusieurs barrettes indépendantes de bornes (soit bornes a) reliées entre elles, la réglette B comprenant deux séries de bornes (soit bornes b et bornes c), les bornes b étant reliées entre elles et les bornes c étant indépendantes. Les deux extrémités de chaque boucle du circuit de commande sont connectées à une réglette B, l'une à une borne b, l'autre à une borne c. La série de bornes b est raccordée à une première borne d'alimentation du circuit de commande, et la borne c, qui est connectée à une extrémité d'une boucle du circuit de commande est également connectée à une extrémité d'un conducteur (appelé "jarretière") dont l'autre extrémité est connectée à une borne a d'une barrette d'une réglette A, ladite barrette étant raccordée à une seconde borne d'alimentation du circuit de commande au moyen d'une autre jarretière. Le cas échéant, la réglette B peut comporter des moyens électroniques de traitement de signaux de commande, tels que, par example des récepteurs-décodeurs pour signaux infrarouges. Comme dans ce dispositif, d'une part toutes les connexions, que ce soit au niveau des barrettes (A, B) de bornes, que ce soit au niveau du bloc de commutation, sont effectuées au moyen de contacts auto-dénudants et que, d'autre part, les modules de commutation sont amovibles et peuvent avoir des fonctions variées, les possibilités de changer instantanément l'affectation des divers actionneurs ainsi que le type de commutation qui leur est associé sont quasi-illimitées. Ce dispositif, en dépit de l'intérêt évident qu'il offre tant aux installateurs qu'aux utilisateurs, présente néanmoins dans certains cas, eu égard aux normes en vigueur en matière d'installations électriques, l'inconvénient de mettre en présence sur le répartiteur, où s'effectue le brassage des extrémités des boucles du circuit de commande et des jarretières sur les barrettes de bornes et le bloc de commutation centralisée, deux circuits parcourus par des tensions différentes.

La présente invention a pour objet de remédier à cet inconvénient grâce à l'interposition d'un dispositif de connexion optique entre le circuit de commande très basse tension et les modules de commutation de puissance d'une installation électrique comportant un circuit double, prévue en particulier pour des locaux d'habitation.

Selon l'invention, on réalise une connexion optique entre le bloc de commutation centralisée, comprenant au moins un module de commutation de puissance, et le circuit de commande très basse tension d'une installation électrique comprenant, outre ledit circuit de commande très basse tension et ledit bloc de commutation centralisée modulaire, un circuit de puissance et des moyens de traitement électroniques des signaux de commande. Le dispositif de connexion optique comporte, au niveau des moyens de traitement électroniques des signaux de commande, une unité de conversion de signaux électriques en signaux optiques et au moins un organe d'émission de signaux optiques et, dans chacun des modules de commutation de puissance, un composant électronique de réception desdits signaux optiques.

Selon une caractéristique de l'invention, le dispositif de connexion comporte en outre un canal de transmission des signaux optiques émis par l'organe d'émission pour le transit desdits signaux entre ledit organe d'émission et le composant électronique de réception. L'organe d'émission ou l'extrémité libre du canal de transmission des signaux optiques est simplement disposé en vis à vis du composant électronique de réception desdits signaux et n'a pas de liaison avec lui, sinon optique.

Selon une autre caractéristique de l'invention, un bloc de commutation centralisée comporte :

. au moins un module de commutation de puissance amovible comprenant un commutateur de puissance assujetti à un organe de transfert thermique et un composant électronique de réception de signaux optiques ;

. au moins un radiateur comprenant au moins une surface pour coopérer étroitement avec l'organe de transfert thermique du module et diffuser la chaleur produite par le commutateur de puissance dudit module ; et,

. des moyens de support pour la fixation du module reliés en un point fixe de leur structure à un organe d'émission de signaux optiques, ledit point fixe étant situé exactement en vis-à-vis du composant de réception de signaux optiques quand ledit module est correctement assujetti auxdits moyens de support.

Le radiateur peut être commun à plusieurs modules de commutation de puissance. Les modules sont avantageusement encliquetables sur les moyens de support.

Selon encore une autre caractéristique de l'invention, les moyens de support d'un module sont constitués par le radiateur, la connexion optique entre le composant électronique de réception de signaux optiques et l'organe d'émission de signaux optiques n'étant réalisée que si la liaison thermique entre l'organe de transfert thermique et le radiateur est assurée.

D'autres caractéristiques et avantages de la présente invention apparaîtront mieux à la lecture de la description qui va suivre, faite en relation avec les dessins annexés, sur lesquels:

la figure 1 est une vue de face schématique d'un répartiteur au niveau duquel est effectuée la connexion optique entre un circuit de commande très basse tension et un bloc modulaire de commutation de puissance;

Les figures 2, 3 et 4 sont des vues en coupe transversales schématiques de trois modes de réalisation préférentiels d'un module de commutation de puissance selon l'invention; et,

les figures 5 et 6 sont des vues en coupe transversales schématiques de deux autres modes de réalisation d'un module de commutation de puissance selon l'invention.

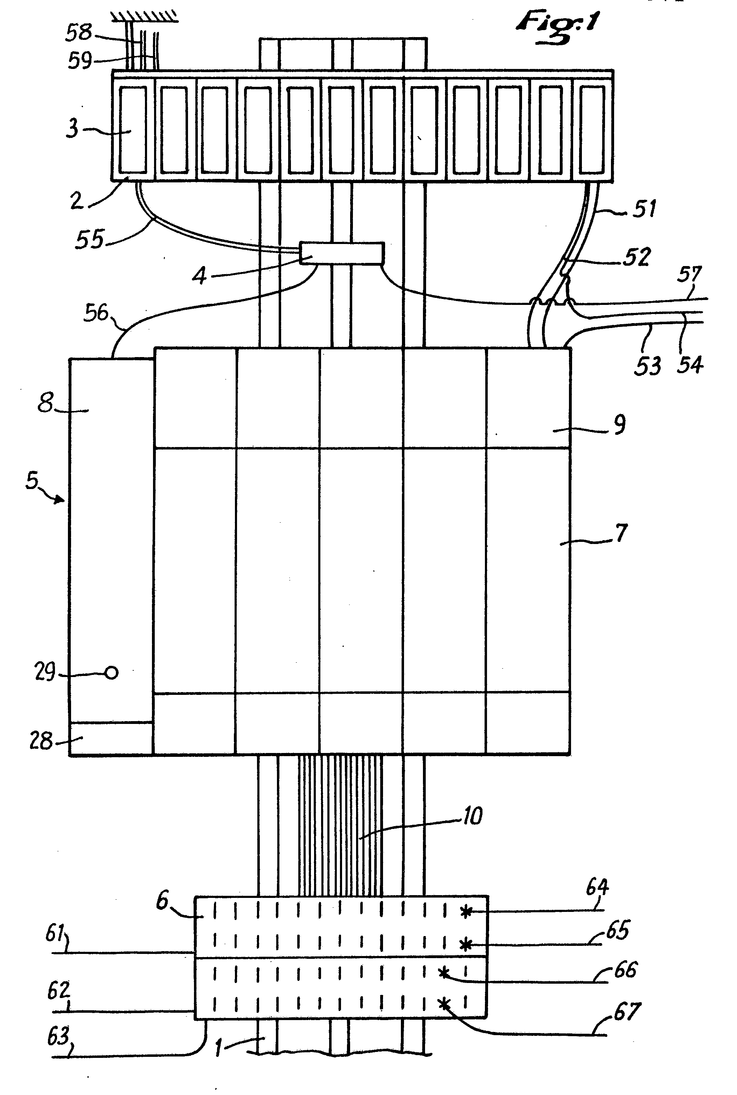

Le répartiteur représenté sur la figure 1 est essentiellement constitué d'un profilé rainuré 1 de métal léger, lequel sert de support à une batterie de bornes d'alimentation 2 protégées par des éléments de protection thermique 3, un bornier de terre 4, un bloc de commutation de puissance 5, au moins une barrette 6 de bornes. Le bloc de commutation de puissance 5 est constitué par la juxtaposition de modules 7 de commutation amovibles et indépendants les uns des autres. Chacun des modules 7, d'un type connu en soi, est assujetti, avantageusement par encliquetage, sur un radiateur 8, destiné à dissiper la chaleur produite par le commutateur de puissance électronique (triac ou équivalent) qu'il contient. Le radiateur 8 est commun à plusieurs modules 7 auxquels il peut servir de support (cas des figures 1,2,3 et 4). Sur la figure 1, le bloc de commutation 5 comporte cinq modules 7 (chiffre arbitraire) assujettis à un radiateur 8 prévu pour en supporter six (chiffre également arbitraire).

Le raccordement des deux circuits composant l'installation se fait de la façon suivante. Chacun des modules 7 est raccordé par une borne d'entrée /sortie de puissance 9, d'une part à une borne d'alimentation 2 (câble de phase 51, câble de neutre 52), d'autre part à une boucle du circuit de puissance (câble de phase commandée 53, câble de neutre 54) comportant un certain nombre de dispositifs lumineux, de prises de courant ou d'appareils électriques (non représentés). Le bornier terre 4 et la batterie de bornes 2, quant à eux, sont raccordés l'un à un câble de terre 55, au radiateur (câble 56) et aux boucles du circuit de puissance (câble 57), l'autre aux câbles de phase et de neutre 58, 59 du secteur.

Les barrettes 6, qui appartiennent au circuit de commande, sont raccordées, d'une part à une alimentation très basse tension (câbles 61, 62, 63, ce dernier servant de commun), d'autre part aux différentes boucles (paires de câbles 64, 65 et 66, 67) du circuit de commande, sur lesquelles est disposé un certain nombre d'actionneurs ou de capteurs (non représentés).

Pour que le circuit de puissance et le circuit de commande soient totalement isolés l'un de l'autre et ne comportent aucune connexion de nature électrique, on prévoit que les signaux émis par les actionneurs et/ou les capteurs, qui sont électriques à l'origine, seront transmis aux modules 7 de commutation de puissance par voie optique. Dans un premier mode de réalisation de l'invention, les barrettes 6 comportent des moyens électroniques de traitement des signaux de commande, dont la fonction minimale est de transformer lesdits signaux électriques en signaux optiques. La transmission de ces signaux optiques, des barrettes 6 aux modules 7, se fait par le canal de fibres optiques 10 dont le raccordement auxdits modules sera décrit en détail plus loin. Outre celui, essentiel, de créer un "tampon" d'isolation entre les deux circuits, l'utilisation des fibres optiques présente de nombreux avantages. En effet, ce canal de transmission des signaux de commande, notamment grâce à sa longueur réduite ainsi qu'à la simplicité de l'information qui l'emprunte, est à la fois très faible et très bon marché. En outre, il permet de réaliser au moyen d'au moins une fibre optique une liaison bilatérale entre un module 7 et une barrette 6, pouvu que ledit module et ladite barrette soient munis tous deux de moyen d'émission et de réception.

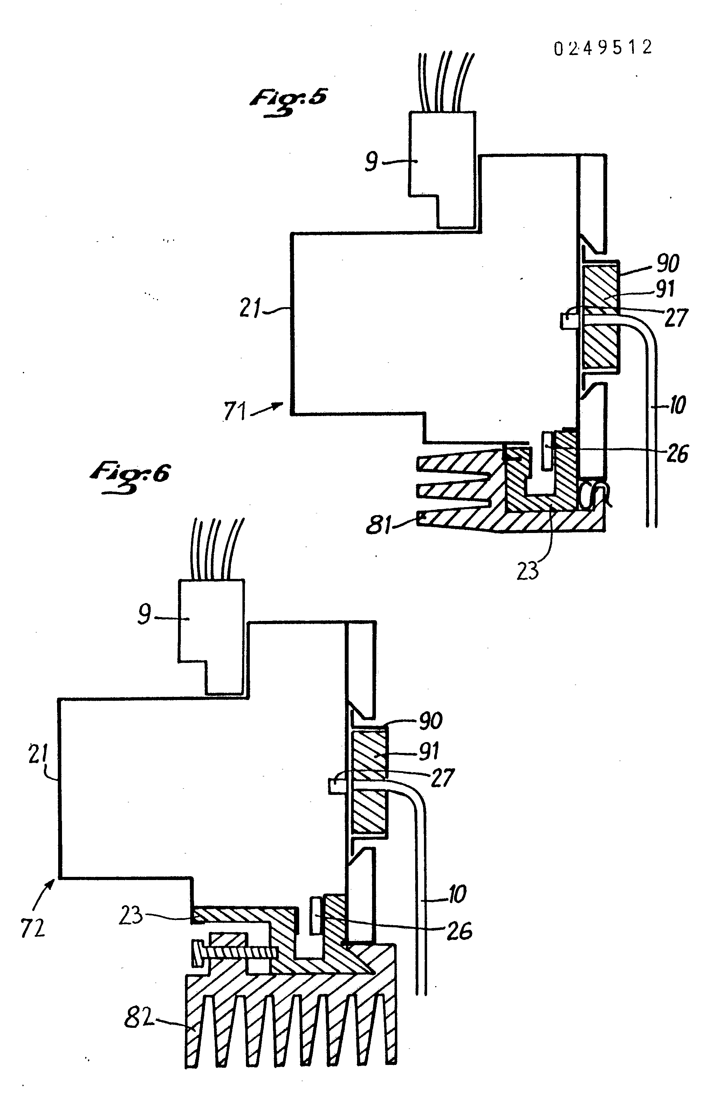

Dans un second mode de réalisation de l'invention, les barrettes 6, qui peuvent n'être que de simples relais de connexion et ne pas comporter de moyens électroniques de traitement des signaux de commande, sont reliées avantageusement par un bus de câbles plats, à une carte de circuit imprimé. Cette carte de circuit imprimé (repérée en 33 sur les figures 3 et 4) comporte des moyens électroniques de traitement des signaux de commande (le cas échéant complémentaires de ceux des barrettes 6) en particulier une unité de conversion des signaux électriques en signaux optiques et au moins un organe d'émission de signaux optiques (repéré en 32 sur les figures 3 et 4). La transmission de ces signaux optiques, de la carte de circuit imprimé aux modules 7, est directe comme on le verra plus en détail ci-dessous.

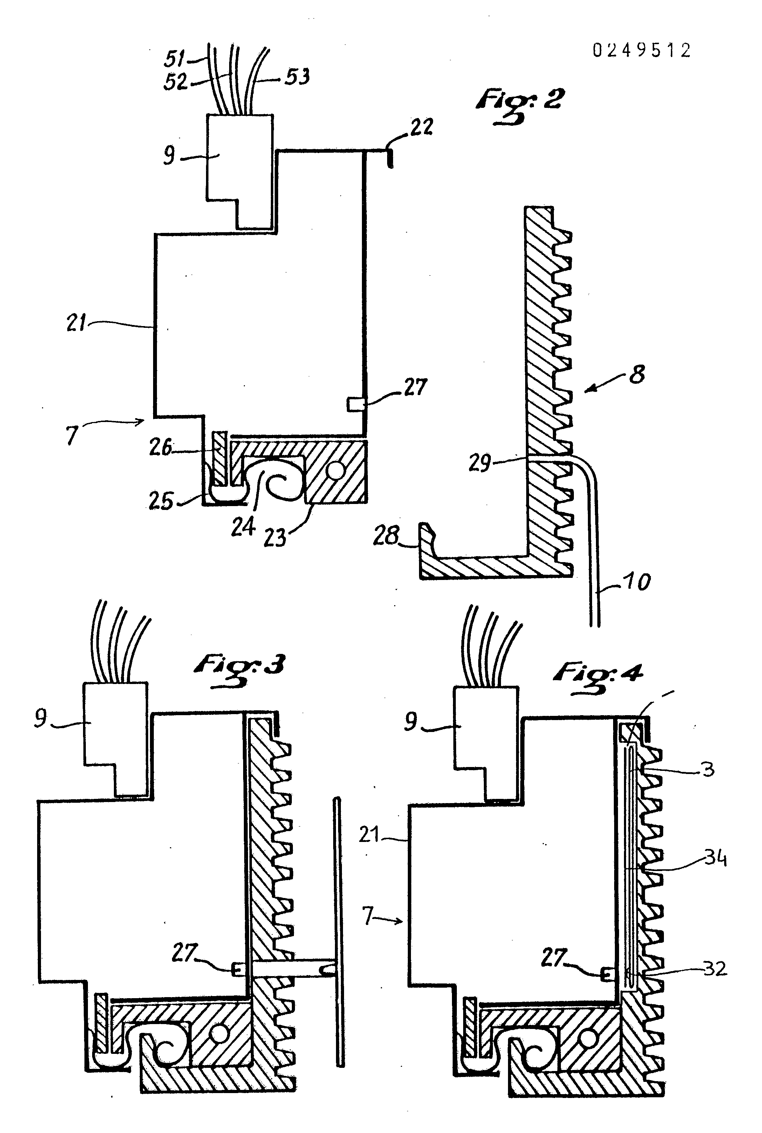

La figure 2, d'une part, et les figure 3 et 4, d'autre part, représentent deux dispositifs de connexion optique correspondant respectivement aux deux modes de liaison entre circuit de commande et circuit de puissance décrits plus haut. Le module 7 représenté en coupe transversale sur les figures 2, 3, 4 comporte un carter 21 muni, à son arête postérieure supérieure, d'un organe d'accrochage 22, une borne d'entrée/sortie de puissance 9 où arrivent trois câbles (51, 52, 53), un élément de transfert thermique 23 comportant un évidement 24 dans lequel prend place un ressort 25 d'encliquetage, un commutateur de puissance au silicium 26 (du type triac ou équivalent) assujetti à l'élément de transfert thermique 23, un phototransistor 27 ainsi que divers composants électroniques (non représentés) dotant le module 7 d'une fonction connue en soi (télévariateur, télérupteur, minuterie, etc.). En fonctionnement, le module 7 est encliqueté sur un radiateur 8, lequel a, vu en coupe, la forme générale d'un "L", comporte un organe d'encliquetage 28 pour coopérer avec le ressort 25 et épouse parfaitement, sur une partie de sa surface, l'élément de transfert thermique 23.

Dans le dispositif de connexion représenté sur la figure 2, le radiateur 8 comporte en outre un trou 29 situé exactement vis-à-vis du phototransistor 27 du module 7, trou 29 dans lequel est assujettie l'extrémité d'une fibre de verre 10 dont l'autre extrémité est connectée à une barrette 6. Dans le dispositif de connexion représenté sur la figure 3, le radiateur 8 comporte également un trou 29 qui, au lieu de recevoir l'extrémité d'une fibre optique 10, accueille un petit tube 31 servant à guider omnidirectionnellement la lumière émise par une diode électroluminescente 32 implantée sur une carte de circuit imprimé 33 qui est disposée derrière le bloc de commutation 5, entre le profilé 1 et l'arrière du radiateur 8. Enfin, dans le dispositif de connexion représenté sur la figure 4, qui est une variante du précédent, le radiateur 8 comporte un évidement 30 dans lequel est logée une carte de circuit imprimé recouverte d'un film isolant transparent 34. Sur cette carte de circuit imprimé est implantée, entre autres composants, une diode électroluminescente située exactement vis-à-vis du phototransistor 27 du module 7.

Une variante des dispositifs représentés sur les figures 2 à 4, moins avantageuse mais également envisageable, consiste à prévoir un assujettissement des module de commutation de puissance 7 sur le radiateur 8 non plus par encliquetage mais par vissage, par blocage à came ou par tout système de fixation similaire.

Les avantages présentés par le dispositif de connexion optique et de fixation mécanique décrit ci-dessus sont nombreux:

En ce qui concerne la fixation mécanique (par encliquetage, vissage, etc.) du module 7 sur le radiateur 8, qui est rendue possible par l'extériorisation dudit radiateur par rapport audit module, elle permet de dimensionner le radiateur 8 pour des charges du circuit de puissance allant jusqu'à vingt ampères, commandées par des modules DIN de 17,5 mm de large seulement. Actuellement, les modules de commutation de puissance utilisés dans les installations électriques de locaux d'habitation sont aux normes DIN et comportent un radiateur incorporé, ce qui entraine l'impossibilité d'évacuer d'importantes quantités de chaleur et limite à deux ou trois ampères l'intensité correspondant à la puissance commutée dans un module de 45 mm de large.

En ce qui concerne la connexion optique du module 7 à la fibre de verre 10 ou à la diode électroluminescente 32, elle s'effectue directement sans nécessiter d'enfichage mécanique. Elle est donc particulièrement fiable. En outre, dans la mesure où, lorsque les modules 7 sont enlevés de leurs radiateurs-supports, l'extrémité des fibres optiques 30 (ou les diodes électroluminescentes 32) est visible, on dispose d'un moyen très simple pour visualiser le fonctionnement des différentes boucles du circuit de commande, et, le cas échéant, pour y repérer les actionneurs ou les capteurs déficients.

De surcroît, la combinaison de cette connexion optique et de cette fixation mécanique outre qu'elle rend le module 7 instantanément amovible, garantit le bon fonctionnement et la longévité des modules de commutation 7. En effet, les signaux transitant par la fibre optique 10 (ou émis par la diode électroluminescente 32) n'atteignent le phototransistor 27 que si ce dernier est juste en face de l'extrémité de ladite fibre optique (ou du petit tube 31), condition qui n'est réalisée que si le module 7 est assujetti correctement au radiateur 8, c'est-à-dire que si le transfert thermique peut s'effecteur convenablement de l'élément de transfert thermique 23 au radiateur 28. Si cette corrélation entre la fixation mécanique, le transfert thermique et la connexion optique n'existait pas, le module 7 pourrait fonctionner, par suite d'un encliquetage partiel par exemple, sans être en contact étroit avec le radiateur 8, d'où il résulterait un échauffement anormal de l'élément de transfert thermique 23 et la détérioration du triac 26.

A titre indicatif, les figures 5 et 6 représentent deux autres modes de réalisation du dispositif de connexion optique selon l'invention, moins avantageux cependant que ceux qui ont été décrits précédemment dans le mesure où leur conformation n'entraîne pas de corrélation entre la connexion optique et le transfert thermique entre le triac 26 et l'air ambiant. Les deux modules 71 et 72, représentés sur ces figures, sont équivalents à ceux des figures 2, 3 et 4 (leurs éléments communs sont repérés par les mêmes chiffres). Ils sont prévus pour s'encliqueter sur un rail 90 assujetti au profilé rainuré 1. Ils comportent également un élément de transfert thermique 23, auquel est assujetti, soit par encliquetage (figure 5), soit par enfichage et blocage à vis (figure 6), un radiateur externe (respectivement 81 et 82), divers composants électroniques (non représentés) les dotant d'une fonction connue en soi (télévariateur, télérupteur, minuterie, etc.), un commutateur de puissance au silicium 26 (triac ou équivalent) et un phototransistor 27, lequel est disposé de façon à être exactement en vis-à-vis de l'extrémité d'une fibre optique 10 maintenue dans le rail 90 par un support 91, lorsque le module 71, 72 est encliqueté sur ledit rail.

La présente invention n'est pas limitée aux exemples de réalisation qui viennent d'être décrits; elle est au contraire susceptible de modifications et de variantes qui apparaîtront à l'homme de l'art.

**Revendications**

1. Bloc de commutation centralisée (5) pour relier un circuit de commande très basse tension et un circuit de puissance, caractérisé en ce qu'il comporte :
:au moins un module de commutation de puissance amovible (7, 71, 72) comprenant un commutateur de puissance (26) assujetti à un organe de transfert thermique (23) et un composant électronique de réception (27) de signaux optiques;
.au moins un radiateur (8, 81, 82) comprenant au moins une surface pour coopérer étroitement avec l'organe de transfert thermique (23) du module (7, 71, 72) et diffuser la chaleur produite par le commutateur de puissance (26) dudit module ; et,
.des moyens de support pour la fixation du module (7, 71, 72) reliés en un point fixe de leur structure à un organe d'émission de signaux optiques (10, 32), ledit point fixe étant situé exactement en vis-à-vis du composant de réception de signaux optiques (27) quand ledit module (7) est correctement assujetti auxdits moyens de support.

2. Bloc de commutation centralisée (5) selon la revendication 1, caractérisé en ce que le radiateur (8, 81, 82) est commun à au moins deux modules de commutation de puissance (7, 71, 72).

3. Bloc de commutation centralisée (5) selon une des revendications précédentes, caractérisé en ce que le module (7, 71, 72) est encliquetable sur les moyens de support.

4. Bloc de commutation centralisée (5) selon une des revendications précédentes, caractérisé en ce que les moyens de support sont constitués par le radiateur (8), la connexion optique entre le composant électronique de réception de signaux optiques (27) et l'organe d'émission de signaux optiques (10, 32) n'étant réalisée que si la liaison thermique entre l'organe de transfert thermique (23) et le radiateur (8) est assurée.

5. Bloc de commutation centralisée (5) selon la revendication 4, caractérisé en ce que le radiateur (8) sert en outre de support à une carte de circuit imprimé (33) à la surface de laquelle est implanté notamment au moins un organe d'émission de signaux optiques (32), ledit organe d'émission (32) étant situé exactement en vis-à-vis du composant de réception de signaux optiques (27) d'un module (7), quand ledit module est correctement assujetti audit radiateur.

6. Bloc de commutation centralisée (5) selon revendication 4, caractérisé en ce que le radiateur (8) comporte au moins un trou (29) pour permettre le passage des signaux optiques émis par un organe d'émission (10, 32), ledit trou (29) étant exactement situé en vis-à-vis du composant électronique de réception (27) d'un module (7) quand ledit module est correctement assujetti audit radiateur.

7. Bloc de commutation centralisée selon la revendication 6, caractérisé en ce qu'une extrémité d'une fibre optique (10) servant de canal de transmission des signaux optiques émis par un organe d'émission est fixée dans le trou (29) du radiateur (8).

8. Bloc de commutation centralisée selon une des revendications précédentes, caractérisé en ce que l'organe d'émission (32) de signaux optiques est une diode électroluminescente.

9. Bloc de commutation centralisée selon une des revendications précédentes, caractérisé en ce que le composant électronique de réception des signaux optiques (27) est un phototransistor.

10. Dispositif de connexion entre le bloc de commutation centralisée (5) selon une des revendictions précédentes et le circuit de commande très basse tension d'une installation électrique comprenant, outre ledit circuit de commande très basse tension et ledit bloc de commutation centralisée (5), un circuit de puissance basse tension et des moyens de traitement électroniques des signaux de commande (6, 33), caractérisé en ce que la connexion est optique et en ce que le dispositif comporte, au niveau desdits moyens de traitement électroniques des signaux de commande, une unité de conversion de signaux électriques en signaux optiques et au moins un organe d'émission de signaux optiques (32).

11. Dispositif de connexion selon la revendication 10, caractérisé en ce qu'il comporte en outre au moins un canal de transmission (10) des signaux optiques émis par l'organe d'émission (32) pour le transit desdits signaux entre ledit organe d'émission et le composant électronique de réception (27) d'un module de commutation (7, 71, 72).

12. Dispositif de connexion selon la revendication 11, caractérisé en ce que le canal de transmission des signaux optiques est un câble à fibres optiques (10).

0249512

Fig.1

0249512

Fig. 2

Fig. 3

Fig. 4

0249512

Fig.5

Fig.6

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int Cl 4) |
|---|---|---|---|
| A | FR-A-2 170 253 (SIEMENS)<br>* Page 4, ligne 38 - page 5, ligne 15; figures 1-3 * | 1,10 | H 01 H 47/00<br>H 05 K 7/20<br>H 02 G 3/00 |
| | --- | | |
| A | FR-A-2 118 991 (GENERAL ELECTRIC)<br>* Page 1, lignes 1-18; page 2, ligne 28 - page 3, ligne 14 * | 1,4,6-12 | |
| | --- | | |
| A | US-A-4 288 839 (PRAGER et al.)<br>* Colonne 4, lignes 26-34; figures 1-3 * | 1,2 | |
| | --- | | |
| A | FR-A-2 533 795 (OTTER CONTROLS LTD)<br>* Page 2, lignes 22-35 * | 1,3 | |
| | --- | | **DOMAINES TECHNIQUES RECHERCHES (Int. Cl.4)** |
| A | FR-A-2 220 935 (TRINKS et al.)<br>* Page 1, lignes 17-25; figures 2,3 * | 1,4,6 | H 02 G 3/00<br>H 01 H 33/00<br>H 05 K 7/00<br>H 01 H 47/00<br>H 02 B 15/00<br>H 02 B 1/00<br>H 01 H 9/00 |
| | ----- | | |

Le présent rapport de recherche a été établi pour toutes les revendications

| Lieu de la recherche | Date d'achèvement de la recherche | Examinateur |
|---|---|---|
| LA HAYE | 06-10-1987 | TIELEMANS H.L.A. |